# EUROPEAN PATENT APPLICATION

(11) **EP 3 076 522 A1**
(43) Date of publication of application: **05.10.2016**
(21) Application number: 14868759.3
(22) Date of filing: 18.04.2014
(51) Int. Cl.: H02K 3/26

(54) **ELECTROMAGNETIC MOTOR**

(30) Priority: 13.12.2013 CN 201310677074
(71) Applicant: Bolymedia Holdings Co. Ltd., Santa Clara, California 95051 (US)
(72) Inventor: HU, Xiaoping, Shenzhen, Guangdong 518055 (CN)
(74) Representative: Manitz, Finsterwald & Partner GbR
(86) International application number: PCT/CN2014/075706
(87) International publication number: WO 2015/085691

(57) **Abstract**

An electromagnetic motor is provided, which may include a stator (11) and a mover (12). One or both of the stator and the mover may be provided with windings. At least one of the windings is made of printed circuit (13). Because of the use of the printed circuit as windings, not only the working hours for forming the windings by copper wires and the copper material are saved, but also accurate circuit design can be achieved, which facilitates the miniaturization of the electromagnetic motor.

## Description

### TECHNICAL FIELD

The present disclosure relates to motors, including electric motors and generators, specifically to electromagnetic motors.

### BACKGROUND

Electromagnetic motors have been developed for about 200 years, which are used for the conversion between electrical energy and mechanical energy based on electromagnetic effects. Because of the reversibility between generator and electric motor, the "motor" mentioned in the present disclosure may include both electric motor and generator, or may also be reversible motor with the dual functions. For simplicity, the present disclosure will be described with reference to electric motor. However, a person skilled in the art will understand that the related technologies may also be suitable for generator.

After a long time of development, a variety of types of electromagnetic motor exist. But usually they all have a stator and a mover. In the present disclosure, the moving part in the motor is referred to as a mover, and the relatively fixed part is referred to as a stator. The motors may be classified based on their respective characteristics. For example, the motors may be classified as DC motors and AC motors based on the drive current, axial motors and disc motors based on the structures of the stators and the movers, motors with excitation windings and motors without excitation windings based on the excitation mode, and rotating motors and linear motors based on the movement of the movers, where the mover of the rotating motor is also referred to as rotor. The different characteristics mentioned above can exist simultaneously to obtain a variety of motors with different forms.

The windings in traditional motors usually are made of copper wires. In order to ensure the consistency of the windings, sometimes specialized equipments for winding are used to make the windings, which leads to that it is difficult for the traditional motors to be used in some applications, such as in micro motors. In such applications, other types of motors have been developed to replace the electromagnetic motors, such as ultra sonic motor (USM). However, the ultra sonic motor also has some drawbacks, such as high operating voltage, poor manufacturing consistency, and low production efficiency in resonance mode, etc.

### SUMMARY

The present disclosure provides an electromagnetic motor including a stator and a mover. One or both of the stator and the mover are provided with windings. At least one of the windings is made of printed circuit.

In the electromagnetic motor according to the present disclosure, the printed circuit is used as windings. Not only the working hours for forming the windings by copper wires and the copper materials are saved, but also accurate circuit design can be achieved, which facilitates the miniaturization of the electromagnetic motor.

The specific embodiments according to the present disclosure will be described in details below with reference to the drawings.

### BRIEF DESCRIPTION OF DRAWINGS

FIG. 1 schematically shows section views of the stator and the mover of an axial motor according to the present disclosure;
FIG. 2 is a schematic view of a winding mode of a 4-layer printed circuit according to the present disclosure;
FIG. 3 is a schematic view of a winding mode of another 4-layer printed circuit according to the present disclosure;
FIG. 4 is a schematic view of a planar arrangement winding mode of a printed circuit according to the present disclosure;
FIG. 5 is a schematic view of the structure of the disc motor of embodiment 1;
FIG. 6 is a schematic view of the magnetic pole face of the mover in embodiment 1;
FIG. 7 schematically shows the end faces of the stator and the mover of the disc motor in embodiment 2;
FIG. 8 schematically shows the assembling of the magnetic cores with the PCB or FPC windings of the stator and the mover in embodiment 2;
FIG. 9 schematically shows the end faces of the stator and the mover of the compound motor in embodiment 3;
FIG. 10 is a schematic view of the assembling of the magnetic cores with the PCB or FPC windings on the end face of the stator in embodiment 3;
FIG. 11 is a schematic view of the structure of the linear motor in embodiment 4;
FIG. 12 is a schematic view of the assembling of the magnetic cores with the PCB or FPC windings of the stator in embodiment 4; and
FIG. 13 is a schematic view of the structure of another linear motor according to the present disclosure.

### DETAILED DESCRIPTION

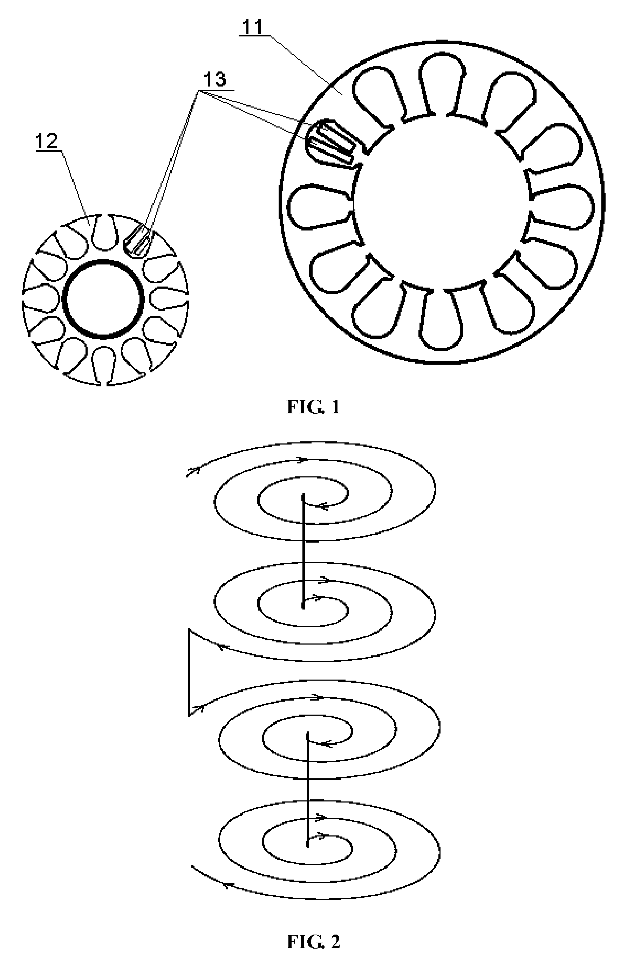

FIG. 1 schematically shows the structure of an electromagnetic motor according to an embodiment of the present disclosure. In general, an axial motor is described in FIG. 1 as an example. However, the motors of the present disclosure may also be other types of motor, such as disc motors or linear motors, etc. In the present embodiment, the motor may include a stator 11 and a mover 12, both of which are provided with windings 13 (for simplicity, only the windings located in one winding slot are shown in FIG. 1). The windings may be made of printed circuit. In other embodiments, based on specific design of the motor, it is possible that only one of the stator and the mover is provided with windings.

The printed circuit of the present disclosure may be formed on a hard board, such as a printed circuit board (PCB), or on a soft board, such as a flexible printed circuit board (FPC). Each of the PCB or FPC may be provided with a single layer of circuit, or may be formed from two or more layers of circuit, such as two, four, six, eight, ten or twelve layers of circuit. The use of multi-layers circuit can significantly reduce the space occupied by the windings, the cost of the wires, the resistance loss and the heating.

The printed circuit may be made of electrically conductive materials, for example, be made of conventional copper or other metals and the composites thereof. In some embodiments, the printed circuit may be made of superconducting materials, thereby the copper loss and heating of the motors can be significantly reduced, the performance and reliability of the motors can be increased, and the size reduction can be facilitated. For example, a stanene single-layer lattice composite film made from a stanene composite superconducting material (professor Zhang Shoucheng, Stanford University) has superconductivity at room temperature at its edges. The use of this superconducting film in the manufacture of PCB or FPC will lead to superior performance.

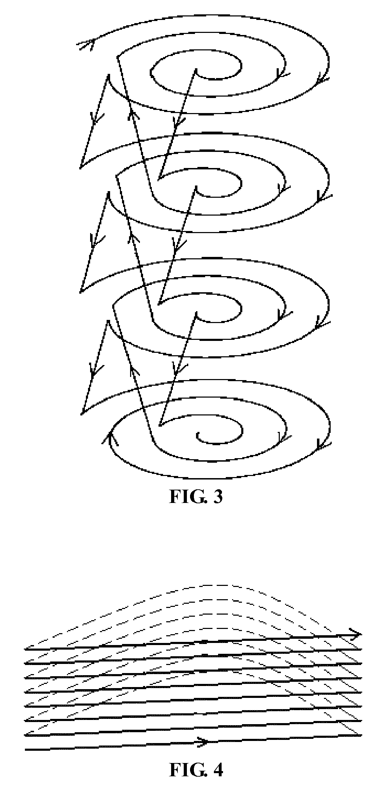

One winding may be implemented by one PCB or FPC, or by a combination of two or more PCBs or FPCs. Based on the mature technologies for manufacturing printed circuit, the structure of the printed circuit may be arranged according to predetermined coil configuration, and the winding required may be obtained by one single unit (one PCB or FPC) or by splicing a plurality of PCBs or FPCs (the wires which are located at the ends and need to be connected may be welded). Referring to FIG. 2, FIG. 3 and FIG. 4, several typical arrangements of printed circuit are shown, in which the arrows indicate the directions of the currents. A person skilled in the art will readily understand that the arrangement and/or the splicing mode of the printed circuit can be correspondingly designed according to the configuration required by the winding. In FIG. 2, a planar spiral winding overlapped in axial direction is shown, where the wire is spirally wound in a single layer first, and then enters into another layer through a perforation and continues to be spirally wound. The spiral circuit in each layer may be one single-layer PCB or FPC, or be one layer of a multi-layer PCB or FPC. The layers are connected by conductive vias (the same below). In FIG. 3, a layered 3D spiral winding nested in radial direction is shown, where the wire is spirally wound between different layers first, and then is three-dimensionally spirally wound from inside to outside (or from outside to inside), which can be regarded as a nesting of several vertical coils with different diameters. In FIG. 4, a planar arrangement winding of the printed circuit is shown, where it is made of FPC and a group of spiral windings can be formed by welding the ends of the FPC according to the dashed lines. The arrangement of the printed circuit in FIG. 4 is also suitable for PCB. However, since the PCB is not able to bend, two or more PCBs are needed, which are spliced to form the spiral windings. Only one layer of wires arrangement is show in FIG. 4. However, there may be a plurality of layers, which can be welded correspondingly.

The winding 13 in FIG. 1 may be made of a variety of suitable printed circuit. For example, the FPC shown in FIG. 4 may be used. One or more FPC (single-layer or multi-layer) may be inserted into the winding slot. After bypassing the corresponding portion of the stator 11 (or the mover 12), the ends of the FPC(s) may be welded together to obtain the windings required. This winding method is simple and has low cost, and the windings made thereby are lighter, and therefore, the loss is smaller. Because of the irregularity of the winding slot, a plurality of PCBs or FPCs may be used for full use of the space. Furthermore, the use of a multi-layer FPC or multiple FPCs can facilitate the increase in the number of turns of the coil. In actual production, in order to facilitate the cooling and the fixation of the windings, a cooling package may also be provided for the PCB or the FPC. For example, thermal glue may be poured into the winding slot into which the PCB or FPC have been inserted.

In the case that it is permitted by the spatial structure, all windings of the stator (or the mover) may be printed on a single PCB or FPC to obtain a more compact and economical motor. The portions of the PCB or FPC on which no circuit is printed may be retained or be perforated as needed so as to cooperate with the mechanical structures of the stator or the mover. It may be designed based on actual requirements.

After the wires are leaded out from the PCB or the FPC, the windings made of the printed circuit may be connected according to required connection mode which may be similar to that of the traditional windings made of copper wires and will not be described in details herein. Therefore, the motor of the present disclosure may adopt a traditional AC or DC drive mode, or adopt a stepping drive mode. In general, the motion control of a stepper motor may be implemented by alternating the polarities of the magnetic poles. One step of the motor corresponds to one position of the magnetic poles. In general, the minimum step precision may be one step or a half step. Because the windings of the motor of the present disclosure are made of PCB or FPC, many control chips can be integrated on the PCB or the FPC, which greatly facilitates the control of the stepper motor.

The electromagnetic motor of the present disclosure will be described below with reference to specific embodiments, where the features which have been described above, such as the winding mode, will not be described again.

### Embodiment 1

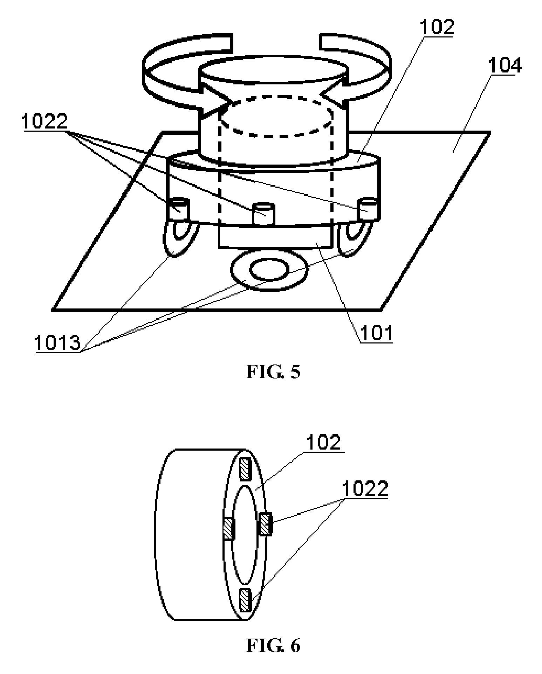

One embodiment of the electromagnetic motor according to the present disclosure is shown in FIG. 5 and FIG. 6, which is a disc motor including a stator 101 and a mover 102. The stator and the mover are hollow and the mover is sleeved at outside of the stator. Specifically, the stator 101 may be a hollow positioning sleeve and be fixed on a substrate 104 (in the present embodiment, the PCB or FPC on which the stator windings are printed). At least one pair of mover magnetic poles 1022 may be mounted at the bottom of the mover. At least two stator windings 1013 may be printed on the substrate (for example, using the winding mode shown in FIG. 2 or FIG. 3). The mover may be sleeved at outside of and be able to rotate around the positioning sleeve. The mover may be a pure iron core. In this case, the magnetic poles 1022 of the mover may be simply embedded in the iron core. The mover may also be made of non-magnetic material such as plastics and the magnetic poles 1022 may be mounted on the surface of or embedded in the non-magnetic material. It is not necessary for the magnetic poles to protrude out of the end face. A casing may be provided such that the magnetic poles are flush with or depressed with respect to the end face of the casing. When AC or DC power is supplied to the stator windings according to certain rules, a rotating magnetic field will be generated between the stator windings and the magnetic poles of the mover. The magnetic field will bring the mover to rotate through the magnetic poles.

In the present disclosure, all stator winding are printed on a single PCB or FPC, which leads to a compact motor. Furthermore, the mover is sleeved at outside of the stator to form a hollow sleeve structure, which may be very useful in some special applications, such as in optical field, where the hollow sleeve structure may be used for the installation of a lens group. In other embodiments, the stator may be sleeved at outside of the mover, or the mover may be solid, which (although may be inconvenient for optical application) may be used for, for example, a mechanical transmission, etc.

### Embodiment 2

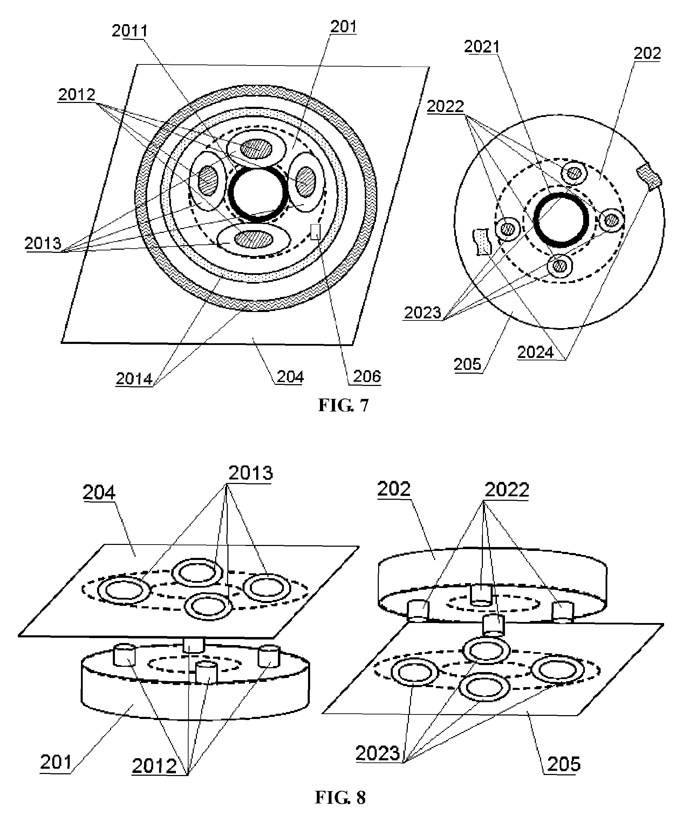

Another embodiment of the electromagnetic motor according to the present disclosure is shown in FIG. 7 and FIG. 8, which is a disc motor including a stator 201 and a mover 202. In comparison with embodiment 1, the main difference is that the mover is provided with mover windings 2023 which serve as excitation windings. Specifically, a rotor sleeve 2021 of the mover may be inserted into a stator sleeve 2011. Two stator electrodes (conductive rings) 2014 may be arranged on a stator substrate 204. Two mover electrodes (conductive spring leaves) 2024 may be arranged on a mover substrate (in the present embodiment, the PCB or the FPC on which the mover windings 2023 are printed) 205 and respectively used to keep electrical connection with the two conductive rings during the rotation, such that the stator 201 can provide power to the mover windings through the conductive rings and the conductive spring leaves.

In the present embodiment, the end face of the mover contacts with the end face of the stator. The mover magnetic poles 2022 are slightly lower than the end face of the mover, while the sizes of the stator magnetic poles 2012 are larger than the holes formed by the depression of the mover magnetic poles. Therefore, no bump will occur when the end face of the mover slides over the stator magnetic poles.

In order to facilitate the measurement of the location of the mover for a precise control thereof, in the present embodiment, the mover magnetic poles 2022 may also serve as Hall magnetic rings. A Hall sensor 206 may be arranged at the stator to measure the location of the mover.

In order to obtain a compact motor, in the present embodiment, all windings 2013 of the stator and all windings 2023 of the mover are printed on single circuit boards (i.e., the substrate 204 and the substrate 205), respectively. In order to obtain a more compact motor and achieve better electrical performance, the stator magnetic poles 2012 and the mover magnetic poles 2022 are formed integrally, respectively. For example, an iron core or a magnetic core made by an integral press molding may be used. The interior of each winding on the substrate 204 and the substrate 205 is provided with through holes, into which the magnetic poles may be inserted, as shown in FIG. 8. In other embodiment, the windings of only one of the stator and the mover are made of one single PCB or FPC, or, the magnetic core of only one of the stator and the mover is formed integrally.

### Embodiment 3

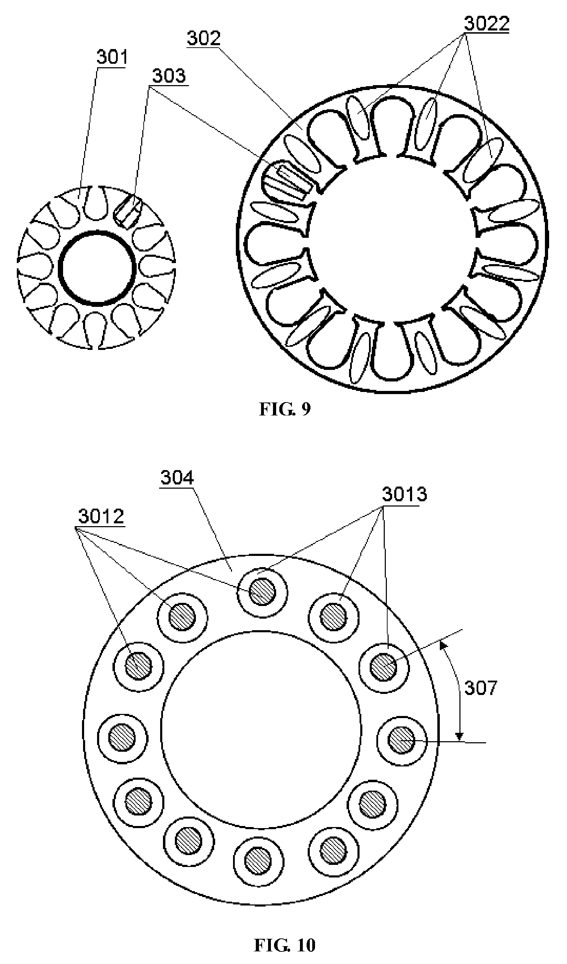

Another embodiment of the electromagnetic motor according to the present disclosure is shown in FIG. 9 and FIG. 10, which is a compound motor based on an axial motor and includes a stator 301, a mover 302 (the magnetic poles of the stator and the mover of the axial motor are not shown) and windings 303 of the axial motor made of PCB or FPC. Magnetic poles and windings of a disc motor may also be arranged at one end face of the stator and/or the mover.

The magnetic poles and windings of the disc motor mentioned above may include the stator magnetic poles and windings (if any) of the disc motor and the mover magnetic poles and windings (if any) of the disc motor. Referring to FIG. 10, the stator magnetic poles 3012 of the disc motor may be integrally formed at the end face of the stator, or may also be individually mounted thereon. The mover magnetic poles of the disc motor may be integrated with the mover magnetic poles of the axial motor, or be separate from the mover magnetic poles of the axial motor in magnetic circuit. The separated mover magnetic poles 3022 of the disc motor may be integrally formed on the end face of the mover, or may also be individually mounted thereon, the magnetic circuit of which may be connected with or separated from the magnetic circuit of the mover magnetic poles of the axial motor. In the case that the mover magnetic poles of the disc motor are integrated with the mover magnetic poles of the axial motor, the disc motor on the end face (referred to as "end face motor" hereinafter) and the axial motor run synchronously. In the case that the mover magnetic poles of the disc motor are separated from the mover magnetic poles of the axial motor, greater degree of freedom and flexibility in design and application can be achieved. For example, the number of magnetic pole pairs of the end face motor and the axial motor may be different. Or, the end face motor and the axial motor may be used for different purpose, for example, one is used for drive, the other is used for excitation. Or, one of the end face motor and the axial motor adopt an AC drive mode, the other adopt a DC drive mode. Or, when used in a vehicle, the end face motor and the axial motor may be used at different stages for different purpose. For example, when the vehicle starts up, both motors are used as electric motors; when the vehicle moves uniformly, only one of the motors is used; when the vehicle brakes urgently, one of the motors is used as a generator and the other is used to drive reversely to shorten the braking distance.

Similar to embodiment 2, the windings of the end face motor (for example, the stator windings 3013 in FIG. 10) may be printed on a single PCB or FPC substrate 304. The interior of each winding may be provided with through holes into which the corresponding stator magnetic poles 3012 are inserted. In the case that the mover of the end face motor is provided with mover windings, the mover windings may be formed in a similar manner.

In order to make the end face motor to function better, in the present embodiment, the structure in which the stator is located at inside and the mover is located at outside may be used, i.e. the magnetic poles and the windings of the stator are surrounded by the magnetic poles and the windings of the mover in the circumferential direction. With such structure, the diameter of the mover is increased, thereby the effective area of the end face motor is increased, and therefore the energy density of the compound motor is increased. In other embodiments, the traditional structure in which the stator is located at outside and the mover is located at inside may also be used. Furthermore, the abovementioned structure in which the stator is located at inside and the mover is located at outside may also be suitable for the axial motor without the end face motor.

Usually both ends of the axial motor are relatively idle, where there is much space which is unused; while the disc motor is relatively idle in the axial direction, where there also is much unused space. Therefore, in the present embodiment, by arranging the disc motor at one end of the axial motor, a compound electromagnetic motor with higher energy density can be obtained, which facilitates the miniaturization of the heavy equipments. It is obvious that, under the guidance of such concepts, the magnetic poles and the windings of the disc motor may be arranged at both ends of the axial motor as needed.

The disc motors (including the compound motor with the end face motor) according to the present disclosure described above have special advantages when a traditional stepping drive mode is adopted, such as better self-locking of the stepping, higher position accuracy of the single step and larger threshold range controlled by the step voltage (or current). The reason is that the electromagnetic force of the disc motor is in the axial direction when the magnetic field is not changed, while the asymmetry of the forces of the magnetic poles in this direction will not lead to any motion of the motor. Therefore, only the asymmetry of the circumferential positions of the magnetic poles will lead to small difference in the accuracy of the positions of the steps of the motor. While, it is easy for the disc motor according to the present disclosure to utilize the integral PCB or FPC windings and magnetic poles, therefore the accuracy can be effectively ensured. For example, with reference to FIG. 10, a span 307 between adjacent two magnetic poles of the stator is one step of the step motor.

### Embodiment 4

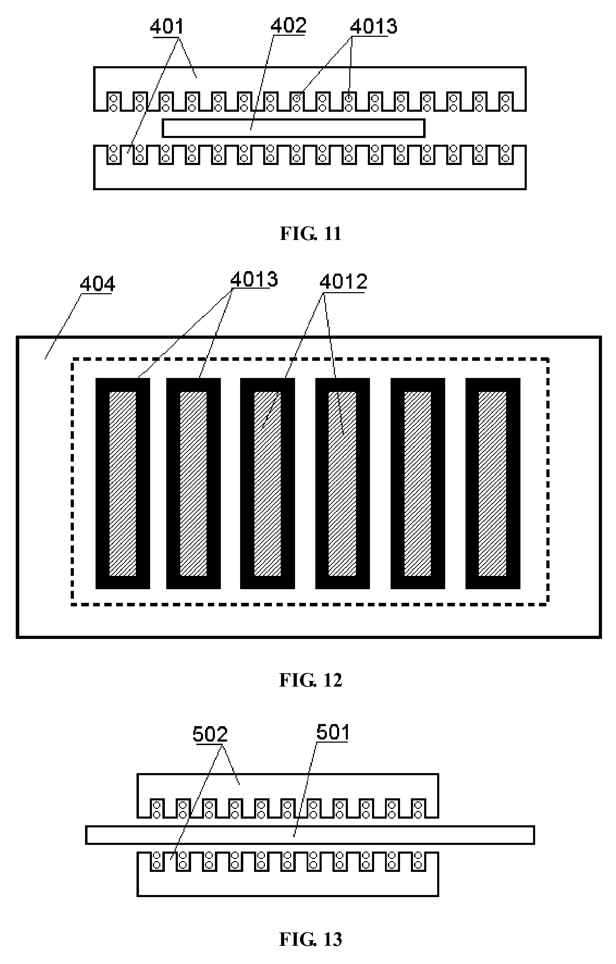

Another embodiment of the electromagnetic motor according to the present disclosure is show in FIG. 11 and FIG. 12, which is a linear motor including a stator 401 (which corresponds to a primary of the linear motor) and a mover 402 (which corresponds to a secondary of the linear motor). The windings 4013 of the stator may be printed on the circuit board and arranged in a row (two layers of wires are schematically shown in FIG. 11, which indicate that the PCB or the FPC may have a plurality of layers). The interior of each winding may be provided with through holes into which corresponding magnetic poles or iron cores 4012 may be embedded (the dashed outline in FIG. 11 represents the underlay portions of the magnetic poles or iron cores sheltered by the circuit board).

It can be seen from the structures described above that, because of the regularity of the shapes, the windings of the linear motor are very suitable for formation by printed circuit on a PCB or FPC. Referring to FIG. 12, all of the stator windings can be formed on a single PCB or FPC substrate 404 with perforations. Both the manufacture and the installation are convenient. Of course, in the case that the stator is very long, a plurality of PCBs or FPCs may also be used. The magnetic poles or iron cores of the stator may be integrally formed by a pressure casting, or may also be formed by assembling a plurality of blocks (or a plurality of pieces) together.

Furthermore, a person skilled in the art will understand that an operation mode in which the secondary is fixed and the primary moves may be used by the linear motor, as shown in FIG. 13 in which the stator 501 corresponds to the secondary of the linear motor and the mover 502 corresponds to the primary of the linear motor. In this case, the structure of the magnetic poles and windings of the mover may be similar to that of the magnetic poles and windings of the stator described above and will not be described in details.

The linear motors described above are all bilateral linear motors. If one of the two stators (or one of the two movers) of the bilateral linear motor is removed, it will become a unilateral linear motors.

The principles and embodiments of the present disclosure have been described with reference to specific examples hereinabove. However, it should be understood that the embodiments described above are merely used to aid in understanding of the present disclosure, but should not be interpreted as limitations thereto. Modification to the specific embodiments described above can be made by those ordinarily skilled in the art according to the concepts of the present disclosure.

## Claims

1. An electromagnetic motor, comprising a stator (1) and a mover (12), wherein the stator and/or the mover is provided with windings, and at least one of the windings is made of printed circuit (13).

2. The electromagnetic motor of claim 1, wherein the printed circuit is formed on a printed circuit board or a flexible printed circuit board, the printed circuit board or the flexible printed circuit board comprises one or two or more layers of circuit, and/or
the printed circuit is made of superconducting materials, wherein the superconducting materials comprises a stanene composite superconducting material.

3. The electromagnetic motor of claim 2, wherein the printed circuit on the printed circuit board or the flexible printed circuit board adopts a planar spiral winding overlapped in an axial direction, and/or a layered 3D spiral winding nested in a radial direction, and/or an end welding winding with planar arrangement.

4. The electromagnetic motor of any one of claims 1-3, wherein the motor is an axial motor.

5. The electromagnetic motor of claim 4, wherein the axial motor is further provided with magnetic poles and windings of a disc motor on one end face of the stator and/or the mover, or
two end faces of the stator and/or the mover are further provided with magnetic poles and windings of a disc motor.

6. The electromagnetic motor of claim 5, wherein the magnetic poles of the disc motor on the end face of the stator are formed integrally; and/or
the magnetic poles on the end face of the mover are integrated with the magnetic poles of the mover of the axial motor, or are separated from the magnetic poles of the mover of the axial motor in magnetic circuit and formed integrally, or are separated from the magnetic poles of the mover of the axial motor in magnetic circuit and individually mounted on the end face of the mover.

7. The electromagnetic motor of claim 4, wherein the magnetic poles and the windings of the stator of the axial motor are surrounded by the magnetic poles and the windings of the mover in a circumferential direction.

8. The electromagnetic motor of any one of claims 1-3, wherein the motor is a disc motor.

9. The electromagnetic motor of claim 8, wherein the stator and/or the mover of the disc motor is hollow, and the stator is sleeved at outside of the mover or the mover is sleeved at outside of the stator.

10. The electromagnetic motor of claim 8 or 9, wherein all windings of the stator or the mover of the disc motor are printed on a single circuit board, or all windings of the stator and all windings of the mover are printed on a single circuit board, respectively.

11. The electromagnetic motor of claim 10, wherein the magnetic poles of the stator or the mover are formed integrally, or, the magnetic poles of the stator and the mover are formed integrally, respectively; and interior of each winding on the circuit board is provided with through holes into which corresponding magnetic poles are embedded.

12. The electromagnetic motor of any one of claims 1-3, wherein the motor is a linear motor, the windings of the stator or the mover of the linear motor are printed on a circuit board and arranged in a row, and interior of each winding is provided with through holes into which corresponding magnetic poles or iron cores are embedded.
